Europäisches Patentamt

(19) European Patent Office

Office européen des brevets

(11) Publication number: **0 450 869 A2**

(12) # EUROPEAN PATENT APPLICATION

(21) Application number: **91302742.1**

(22) Date of filing: **28.03.91**

(51) Int. Cl.$^5$: **G03F 7/26**

(30) Priority: **03.04.90 US 504149**

(43) Date of publication of application:
**09.10.91 Bulletin 91/41**

(84) Designated Contracting States:
**DE FR GB**

(71) Applicant: **Hewlett-Packard Company
Mail Stop 20 B-O, 3000 Hanover Street
Palo Alto, California 94304 (US)**

(72) Inventor: **Hargreaves, John S.
575 So. Rengstorff, No.45
Mountain View, California 94040 (US)**

(74) Representative: **Colgan, Stephen James et al
CARPMAELS & RANSFORD 43 Bloomsbury
Square
London WC1A 2RA (GB)**

(54) **Image reversal in a negative deep ultraviolet photoresist.**

(57) A method for image reversal, beginning with a negative photoresist material that is patterned by electromagnetic radiation at wavelengths of the order of $\lambda = 250$ nm. A negative resist material, Shipley SNR 248, is modified by addition of an amine-containing base compound such as 1,2,4-triazole to form a photoresist-base ("PB") mixture. A film containing the PB mixture is baked (optional), exposed to narrow band light at $\lambda = 248$ nm, using a photomask for the desired pattern, so that insufficient acid remains in the exposed portion of the film to promote cross linking. The base in the exposed portion of the film is removed by low temperature post-exposure bake so that no further cross linking occurs. The film is then uniformly exposed with a dose sufficient to cross link the previously-unexposed portion of the film, and the film is baked again at a low temperature. The film is then developed, producing a positive image of the original pattern.

EP 0 450 869 A2

Technical Field

This invention relates to image reversal in a photoresist material.

Background of the Invention

Where very small patterns with fine detail are to be formed for purposes such as manufacture of high density integrated circuits, a photoresist material is often used to provide the delicate patterns required. A photoresist film is typically 1-3 μm thick and the size of the desired pattern may have details that are 1 μm or less in thickness. If a photoresist material is used for such purposes, the photoresist material is covered with a photomask that delineates the desired features, and the photomask plus photoresist is irradiated by electromagnetic radiation or particle beams at an appropriate energy. Where a negative type photoresist material is used, the portion of the material that was exposed to light through the photomask will remain and the unexposed photoresist material may be removed by subsequent development in an appropriate developer. Where a positive type photoresist material is used, the material that was exposed is removed by subsequent development and the unexposed material remains.

Negative acting photoresist films have a tendency to swell during the step of resist development, because organic solvents and other materials employed as developers are incorporated in the exposed portions of the film during the development step, although this swelling has been suppressed with some recent work. Because of this, it is sometimes difficult to form a pattern such as a hole or aperture line with small tolerance on the diameter, using negative resist; and it is difficult to form an open trench having a narrow open gap with small tolerance between two adjacent walls of photoresist material because the negative resist swells and partially blocks the desired open channel. Positive acting photoresist materials do not swell upon development. However, forming an isolated narrow line with small tolerance on line thickness is more difficult to obtain using a positive resist than is formation of the same line using a negative resist. Positive resist materials have become the choice for many, but not all, high resolution applications. For some applications it is still more convenient to use negative acting photoresist materials, especially where a pattern is to be prepared that will be mostly dark with a few clear areas. Thus, the possibility of beginning with a photoresist material of one type (e.g., positive) and converting it during processing to a photoresist material of opposite type (e.g., negative) through image reversal, is an attractive specter.

Kaplan et al. and Moritz et al., in U.S. Pat. Nos. 4,007,047 and 4,104,070, respectively, disclose methods for image reversal, beginning with a positive acting photoresist material such as diazo ketone resist/resin 1-hydroxyethyl-2-alkyl-imidazoline. This material is applied to a substrate, exposed through a photomask to low wavelength radiation, heated, blanket exposed to low wavelength radiation, and developed with a solvent to remove the originally-unexposed portions of the photoresist to yield a negative image.

Leyrer et al., in U.S. Pat. No. 4,456,679 disclose another image reversal process in which the initial photosensitive layer contains a compound with two or more aromatic and/or heteroaromatic O-nitrocarbinol ester groups, a compound to promote cross linking, and two or more chemical groups that can react with a carboxyl group (COOH) to form a covalent chemical bond. The photosensitive layer is then exposed through a photomask to low wavelength light, and the exposed areas of the layer are removed with an aqueous developer. The resulting image is then irradiated uniformly with low wavelength light and cross linked and hardened by baking.

Preparation of positive acting and negative acting photoresist compositions with an acid-generating photoinitiator are disclosed in U.S. Pat. No. 4,491,628 issued to Ito et al. The photoresist material combines a polymer that has recurrent acid labile pendant groups with a cationic photoinitiator such as aryl-diazonium, diaryliodonium or triarylsulfonium metal halides. The photoresist material is baked, then exposed to radiation through a photomask, then post-baked, and the exposed areas are selectively removed by treatment with an alkaline developer or polar solvents. The unexposed portions of the film remain nonpolar and may be selectively removed by treatment with a nonpolar solvent. This approach relies on side chain cleavage rather than upon cross linking or main chain degradation.

Field et al., in U.S. Pat. No. 4,546,066 rely in part upon diffraction effects through overexposure of a positive acting photoresist material through a photomask to produce partly exposed areas adjacent to the boundaries of the photomask. The photoresist material is preferably naphthoquinone (1,2) diazide sulfonic acid ester sensitizer plus 1-hydroxyethyl-2-alkyl-imidazoline. The photoresist material is exposed through a photomask for a sufficient time to partly expose regions under the photomask that are adjacent to but covered by the boundaries thereof. The photoresist material is then heated to render the exposed areas insoluble in developer, then uniformly exposed with low wavelength radiation. The portions of the photoresist that were not exposed or partially exposed are then removed with a developer, thereby providing photoresist-covered regions that are narrower than the opaque portions of the photomask. This process relies upon substantial overexposure of the pattern through the photomask.

In U.S. Pat. No. 4,567,132, Fredericks et al. disclose a photoresist photolithographic process that requires a single development step to develop a dual layer photoresist for purposes of pattern liftoff, reactive ion etching or ion implantation. The photoresist material contains a first layer that is soluble in a developer after exposure to light and baking and contains a second layer that is insoluble in the developer after exposure to light and baking. Using the opposite characteristics of these two adjacent layers, an effective aperture for a window in the composite photoresist material can be tightly controlled in cross sectional dimensions. The bottom layer of the photoresist material is a positive resist such as phenol-formaldehyde resin with a diazonaphthoquinone sensitizer. The upper layer is a negative photoresist such as the above resin-sensitizer mix combined with one percent by weight of 1-hydroxyethyl-2-alkyl-imidazoline. This photoresist and associated processing is useful for forming hourglass-shaped photoresist structures.

Image reversal, beginning with a positive action photoresist, is also disclosed by Badami et al. in U.S. Pat. No. 4,568,631. A substrate is covered with a positive photoresist that contains an additive such as one percent alkyl imidazoline to promote image reversal. The photoresist is then exposed through a photomask, and the edges of the opaque mask regions become partially exposed through light diffraction at the edges. The photoresist is developed in a solvent to remove exposed portions thereof, and the remaining photoresist is baked to cause a hardening reaction in the partially exposed regions that were not removed. This reaction is driven by decomposition products formed during the partial exposure. The major portion of the remaining photoresist (in the unexposed regions) do not react during the baking step because they contain none of these decomposition products. The hardening reaction freezes the solubility of the partially exposed areas relative to the solubility of the unexposed areas. The photoresist is then uniformly exposed to increase the solubility of the unexposed regions. Subsequent treatment of the photoresist material with a second developer removes the unexposed portions, and only the thin portions of the photoresist adjacent to the mask edges remain. Photoresist lines of the order of 0.5-2.0 μm in thickness can be formed by this approach, or the process can be reduced to produce narrow trench isolation regions. A somewhat analogous process, using selective ion implantation to promote the development of narrow insoluble regions, is disclosed by Kerbaugh et al. in U.S. Pat. No. 4,799,990.

In U.S. Pat. No. 4,775,609, McFarland discloses an image reversal process that begins with a positive action photoresist material including a hydrophobic blocked polymer. The photoresist is exposed through a photomask to produce photogenerated acid in the exposed portions, and the photoresist is then treated with a gaseous base such as ammonia. The base reacts with the photogenerated acid that prevents deblocking of the polymer and maintains its insolubility. Excess base is then removed and the photoresist is uniformly irradiated with ultraviolet light. This produces acid in the previously unexposed areas. Sensitizer has already been largely destroyed in the originally-exposed area so that little acid is produced there. The photoresist is then baked to deblock the polymer in the originally-unexposed regions, and these regions are subsequently removed by development in an aqueous alkali. The resulting image is a negative action pattern that is the reverse of the original masking pattern.

Careful attention to thermal processing details is relied upon by Ziger in U.S. Pat. No. 4,814,243 to produce an image reversal process. A positive photoresist material is exposed through a photomask to light and is baked in the presence of an amine gas. Baking causes the exposed portion of the resist material to be insoluble in the basic amine gas, and only the unexposed regions of the resist material are affected by the gas. The film is subsequently developed by selectively dissolving the originally-unexposed regions in a base solution to produce a negative of the original image. The time and temperature details of the baking step are controlled by a computer that constantly monitors the environment in the oven and is controlled by an algorithm to produce optimal reactions in the originally-unexposed regions of the photoresist material.

Thackeray et al., in Deep UV ANR Photoresists for 248 nm Excimer Laser Photolithography", Advances in Resist Technology and Processing VI, S.P.I.E. vol. 1086, 1989, pp. 34-47, present some experimental results for two negative photoresist materials, XP-4388 (now SNR 248) and XP-8866, developed through a joint research venture between Shipley Company, Newton Lower Falls, Massachusetts, and Rohm & Haas Company, Philadelphia, Pennsylvania. The photoresist materials SNR 248 and XP-8866 are phenolic-based and novolac-based, respectively, and both show low or modest light absorbance ( $\leq 0.5$ ) in a range of deep ultraviolet wavelengths around $\lambda = 0.25$ μm. Thackeray et al. report some experimental results, such as absorbance versus wavelength and normalized resist film thickness versus exposure dose, for conventional processing of these two materials as negative type photoresists.

What is needed is a procedure and appropriate materials for image reversal so that an initially negative type photoresist may be converted by appropriate processing and produce a positive image of the desired pattern after processing.

Also needed is a procedure for image reversal that identifies and assigns to their optimal ranges image reversal process parameters with respect to which the image reversal process is most sensitive.

## Summary of the Invention

These needs are met by a method that begins with a negative type photoresist material that has very low absorbance (< 0.5) in at least a limited range of deep ultraviolet wavelengths. An example of such a material is the Shipley SNR 248 photoresist material. A basic compound such as 1,2,4 triazole of atomic fraction 0.5-4 percent is added to and mixed with the photoresist material, and a film of the mixture of thickness 0.5-2 μm is formed. A portion of the mixture is exposed to ultraviolet light of an appropriate wavelength such as the range $\lambda = \lambda_1 = 240\text{-}265$ nm for a time interval of length $\Delta t = \Delta_{t1} = 15\text{-}180$ sec (dose rate at 20-270 mJ/sec), where the exposed portion of the mixture is defined by a photomask positioned between the ultraviolet light source and the mixture. As a result of this exposure, the photoresist component in the exposed portion of the mixture forms an acid with which the adjacent base component reacts so that the exposed photoresist component is thereby neutralized. The photoresist-base mixture is then heated to a temperature in the range $T = T_2 = 353\text{-}383°K$ at a pressure of $p = p_2 = 6 \times 10^4$ Pascals or lower for a time interval of length $\Delta t = \Delta t_2 = 75\text{-}600$ seconds to allow the unexposed portion of the base (triazole) to evaporate from the mixture. The remainder of the mixture is then exposed uniformly to light of a second wavelength in the range $\lambda = \lambda_2 = 240\text{-}260$ nm for a time interval of length $\Delta t = \Delta t_3 = 15\text{-}75$ sec. The remaining photoresist-base mixture is then heated to a temperature in the range $T = T_3 = 363\text{-}413°K$ at approximately atmospheric pressure ($p = p_3 = 10^5$ Pascals) for a time interval of length $\Delta t = \Delta t_4 = 30\text{-}90$ sec. The remaining mixture is then developed by appropriate means to produce a positive image of the original photomask pattern. Optionally, the photoresist-base mixture may be prebaked at a temperature in the range 343-413°K for a time interval in the range $\Delta t = \Delta t_5 = 30\text{-}90$ sec, before the mixture is exposed to ultraviolet light of wavelength $\lambda = \lambda_1 = \simeq 250$ nm. This procedure allows image reversal, beginning with an initially negative type photoresist material so that a positive image of the photomask pattern is thereby obtained.

The material that forms the positive image after this procedure is completed has very good plasma etch resistance and may be used to define patterns in semiconductor integrated circuits with resolution as low as 0.41 μm. Side walls in the positive image are vertical to within a few degrees. The initial photoresist material used, Shipley SNR 248 or another suitable negative resist, appears to have a shelf life of at least six months and to be thermally stable for temperatures up to at least 473°K.

## Brief Description of the Drawings

Fig. 1 is a graphical view of absorbance versus wavelength for one deep ultraviolet photoresist material, SNR 248, used in practicing the invention.

Fig. 2 is a graphical view of absorbance versus wavelength for a photoresist material of interest, showing the effects of exposure to the material to prebaking at a high temperature and exposure to ultraviolet light at the wavelength indicated.

Figs. 3 and 4 are graphical views of the experimentally determined normalized photoresist film thickness versus radiation dose for a sequence of post-exposure baking temperatures and a sequence of post-exposure baking times, respectively.

Fig. 5 is a pseudo-Arrhenius plot for the information given in Fig. 3.

Fig. 6 is a graphical view of radiation dose versus post-exposure baking time for the information given in Fig. 4.

Figs. 7 and 8 are graphical views of experimentally determined normalized photoresist film thickness versus the effective dose of ultraviolet radiation, computed according to a theoretical model from the information obtained from Figs. 3 and 4, respectively.

Figs. 9 and 10 are graphical views of experimentally determined photoresist film thickness versus the weight percentage of 1,2,4 triazole added to the photoresist material SNR 248 for a fixed radiation dose of 1.5 J/cm², without and with prebaking of the photoresist-triazole mixture, respectively.

Fig. 11 is a graphical view of experimentally determined normalized photoresist film thickness versus radiation dose where a pre-exposure baking step of the photoresist-triazole mixture is included.

Fig. 12 is a graphical view of theoretically determined effective radiation dose versus post-exposure baking time for a sequence of post-exposure baking temperatures.

Fig. 13 is a graphical view of experimentally determined normalized photoresist film thickness versus radiation dose for a sequence of post-exposure baking times necessary to remove the remaining amine base mixture (triazole) from the photoresist-triazole mixture.

Fig. 14 is a graphical view of post-exposure baking time versus radiation dose for a sequence of post-exposure baking temperatures necessary to remove the amine, as in Fig. 13.

Fig. 15 is a graphical view of a measure of the amount of photoresist remaining versus radiation dose, where a pre-exposure bake of the photoresist-triazole mixture, a post-exposure bake of the remaining mixture and a subsequent uniform radiation exposure is given.

Best Mode for Carrying Out the Invention

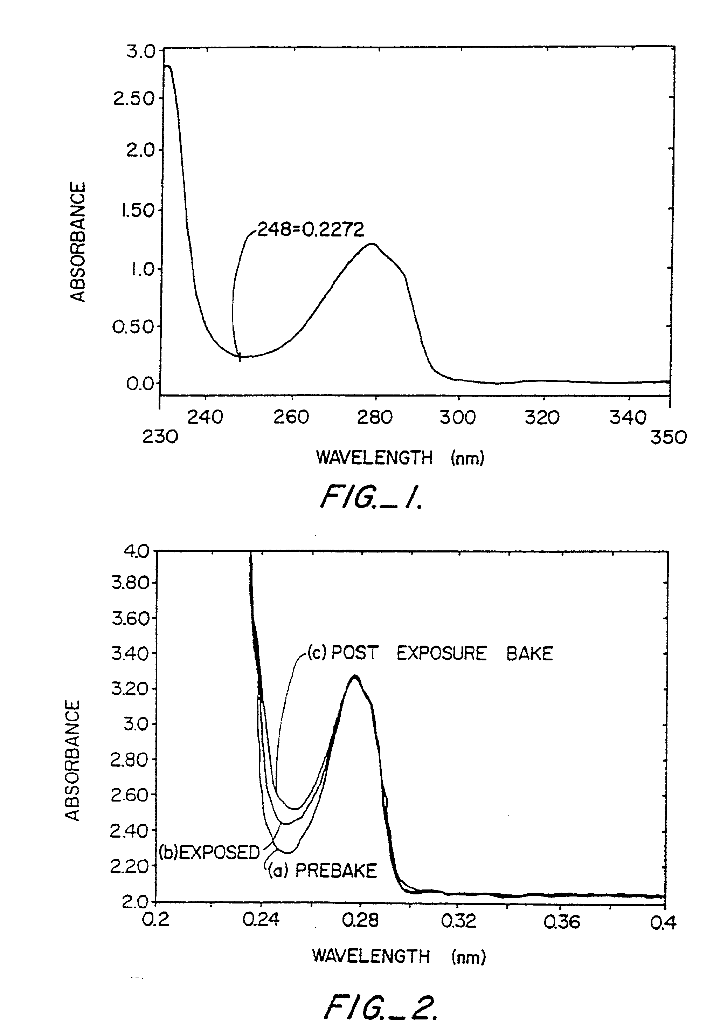

With reference to Fig. 1, the Shipley photoresist material SNR 248 with a 1 μm thickness shows an attractive minimum in light absorbance for deep ultraviolet wavelengths in the range $\lambda$ = 240-260 nm, where the absorbance is in the range 0.3-0.35. The absorbance numbers depend upon the pre-exposure conditioning of this photoresist material and may be made even smaller, as low as 0.22 at the wavelength $\lambda$ = 248 nm. The SNR 248 resist material is phenolic-based and contains an energy sensitive cross linking system that produces a negative image of the pattern after post-exposure baking and development.

Fig. 2 is a plot of absorbance versus wavelength for (a) pre-baked but unexposed SNR 248, (b) exposed SNR 248 material and (c) exposed and post-baked SNR 248 material, illustrating how the absorbance parameter varies in the wavelength of interest with the processing steps that have been applied to the material. Pre-exposure baking of the photoresist material produces no substantial change in absorbance for modest baking times. Exposure of the SNR 248 material after baking leads to a slight darkening of the resist film in the wavelength interval of interest ($\lambda$ = 240-265 nm), possibly due to reaction products produced during acid generation in this exposure step. Post-exposure baking, after pre-exposure baking and exposure, causes a substantial darkening of the film in the wavelength interval of interest, probably due to cross link formation in the material.

The invention provides image reversal of negative photoresist material such as SNR 248 from negative to positive, using an acid-generating additive, 1,2,4triazole in the amount of 0.5-4 parts triazole to 100 parts photoresist to form a photoresist-triazole ("PT") mixture. The PT mixture is coated on a silicon wafer that has been primed with hexamethyldisilazane before use. Pre-exposure baking at normal atmospheric pressure was used to produce a final film thickness of about 1 μm.

Radiation exposures of the film were performed on an Oriel contact printer with a narrow band pass filter centered at wavelength $\lambda$ = 248 nm. For purposes of standardization, the dose required to cross link the resist is taken here as the dose necessary to give a value of 0.5 for the normalized film thickness remaining after partial cross linking has occurred. Post-exposure development of the film was by agitation in a solution of Shipley MF 319 developer for a time interval of $\Delta t$ = 30-60 sec at ambient temperature T = 300°K.

The SNR 248 negative resist material uses a resin, poly(hydroxystyrene), that contains a melamine cross linker and a photoacid generator ("PAG"). Upon exposure to deep ultraviolet radiation, the PAG produces an acid that catalyzes a cross linking reaction between the resin and the melamine during subsequent thermal processing. The acid is regenerated so that one photon may give rise to many cross links.

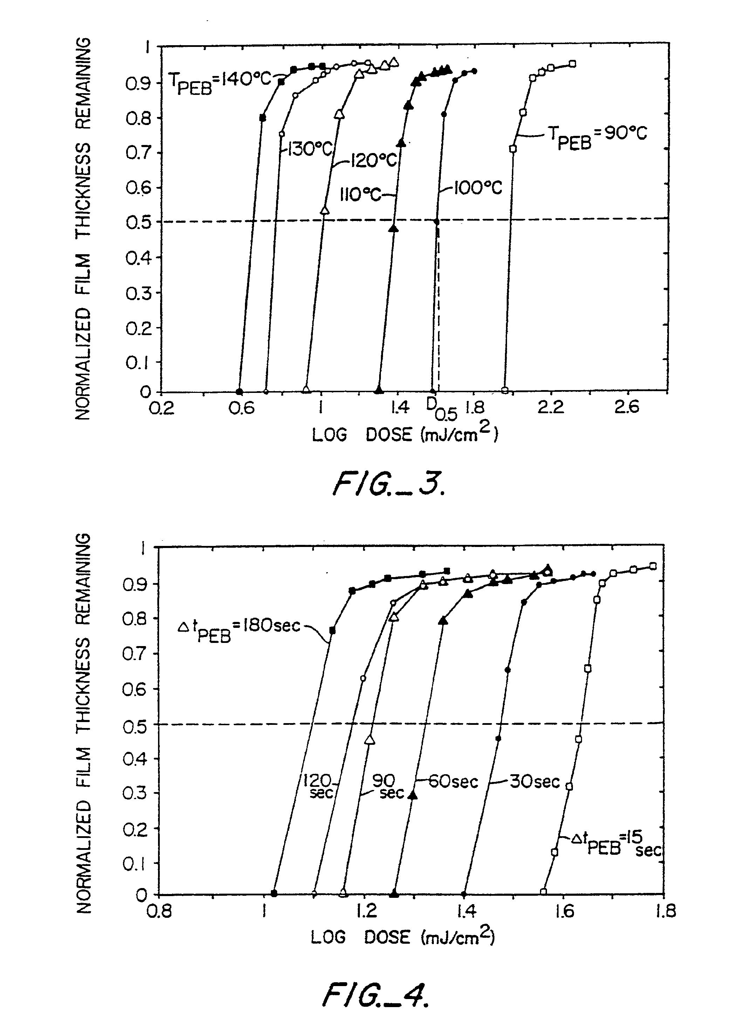

The sensitivity of the photoresist material SNR 248 is highly dependent on the initial exposure dose and on the details of subsequent thermal processing. Fig. 3 is a plot of normalized film thickness remaining versus radiation dose in which the post-exposure bake temperature $T_{peb}$ has been varied from T = 363-413°K. The contrast of this material, measured by the slope of the curves in Fig. 3, is approximately unchanged with change in $T_{peb}$. However, the sensitivity of this resist, measured by the dose at which the normalized film thickness remaining reaches 0.5, increases with increasing $T_{peb}$.

Fig. 4 illustrates the normalized film thickness remaining versus dose for a sequence of irradiation times $\Delta t_{peb}$ = 15-180 sec, where the temperature $T_{peb}$ has been kept constant. Again, the sensitivity increases with increasing post-exposure bake time $\Delta t_{peb}$.

Seligson et al., in Jour. Vac. Sci. Tech. B, Volume 6 (1989), pp. 2303-2307, have proposed a model for thermally activated photoresist materials that attempts to explain the changes in sensitivity with changing post-exposure bake conditions. These workers have derived an equation

$$D_{eff} = D\ exp[E_\cdot/RT_{peb}](\Delta t)^{1/m}, \quad (1)$$

where $D_{eff}$ is the effective dose, D is the incident dose, $E_\cdot$ is the effective activation energy for cross linking, R is the gas constant, $\Delta t$ is a normalized bake time, and m is the kinetic order of the acid reaction. According to the Seligson et al. equation, similar sensitivities may be obtained for different process parameters that give the same value of the effective $D_{eff}$.

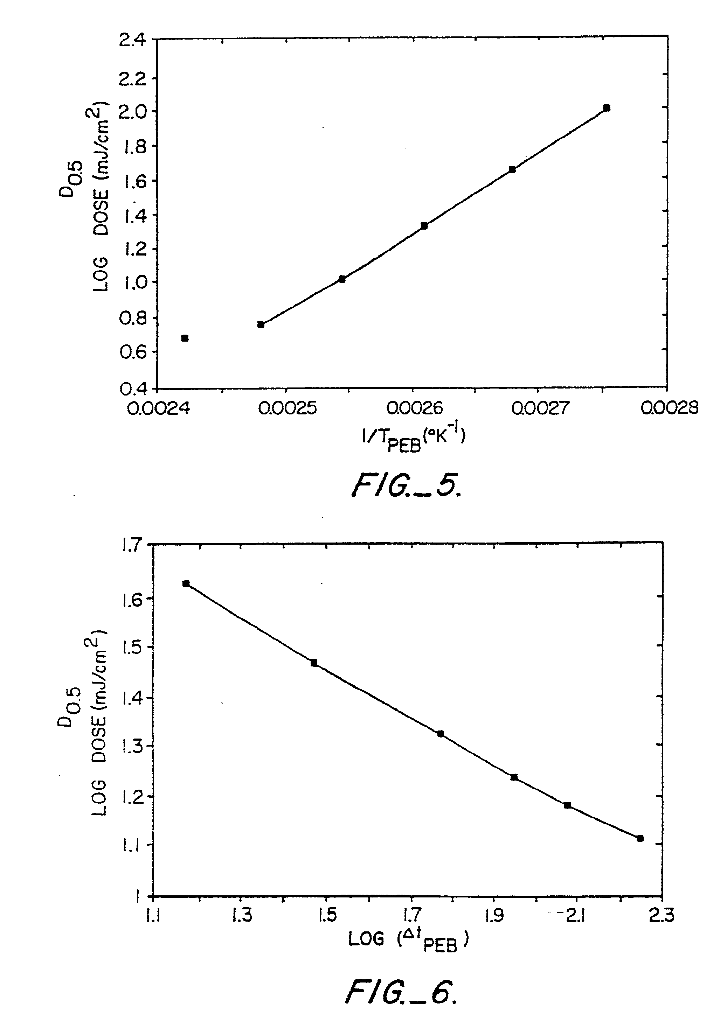

Fig. 5 is a pseudo-Arrhenius plot, using the information from Fig. 3, of $D_{0.5}$ versus $T_{peb}$, with $\Delta t_{peb}$ held constant. An effective activation energy of about 85 kJ/mol = 20.3 kcal/mol, or about 0.88 eV/atom, is obtained here. This may be compared with a value of 35-45 kJ/mol obtained by Thackeray et al. in "Deep UV ANR Photoresist for 248 nm Excimer Laser Photolithography", S.P.I.E. Proc., Volume 1086 (1989), pp. 34-47. Although the contrast for SNR 248 depends upon the substrate being used, being about three for quartz substrates and about six for silicon substrates, the effective activation energy $E_\cdot$ shows no dependence on substrates.

Fig. 6 is a plot of the dose $D_{0.5}$ versus $\Delta t_{peb}$ for the information contained in Fig. 5. The derived value of the reaction order m is approximately 2. Values of m of 2.5-3 have been obtained by other workers for SNR 248 and similar resist materials.

Using the experimentally determined values of $E_\cdot$ and m and sensitivities (measured by $D_{0.5}$), the Seligson et al. relation, Eq. (1), may be used to determine similar but differing process conditions that should lead to the same value for effective dose $D_{eff}$.

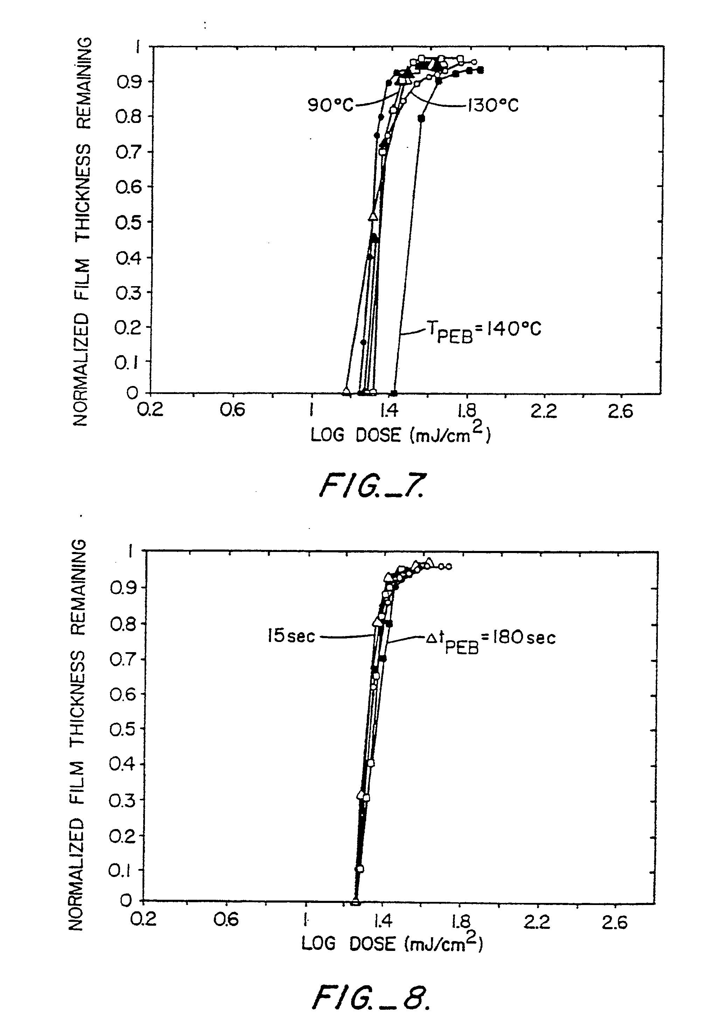

Fig. 7 is a plot of normalized film thickness remaining versus effective dose $D_{eff}$, using the information obtained from Fig. 3 and the experimentally determined values for $E_*$ and m. The data have been normalized to a standard post-exposure baking process with $T_{peb}$ = 383°K and $\Delta t_{peb}$ = 60 sec. Although the curves for different values of $T_{peb}$ do not fall precisely on one another, the curves do show good overlap, except at the highest temperature used, $T_{peb}$ = 413°K. This discrepancy is believed to be due to photoresist burning.

Fig. 8 is a similar plot of normalized film thickness remaining versus effective dose $D_{eff}$ for the information obtained from Fig. 4. Here the overlap is very good for all values of $\Delta t_{peb}$. The results from Figs. 7 and 8 strongly suggest that the Seligson et al. model and Eq. (1) adequately account for differences in processing of such photoresist materials. However, it should be kept in mind that the sensitivity of photoresist materials such as SNR 248 is dependent upon the subsequent processing conditions, especially on $T_{peb}$. Using the model of Seligson et al. for a specified dose D, the post-exposure bake processing conditions required to cross link the material may be determined from Eq. (1). This information is necessary in order to cause image reversal in a material such as SNR 248.

In order to achieve image reversal in a material such as SNR 248, the process responsible for cross linking the resist must be selectively inhibited. This is accomplished here by neutralizing the acid species with an adjacent base, here chosen to be 1,2,4 triazole. The triazole base does not absorb light at a wavelength $\lambda$ = 248 nm and can thus be added to solutions of SNR 248 without change in the absorbance of the thin films formed.

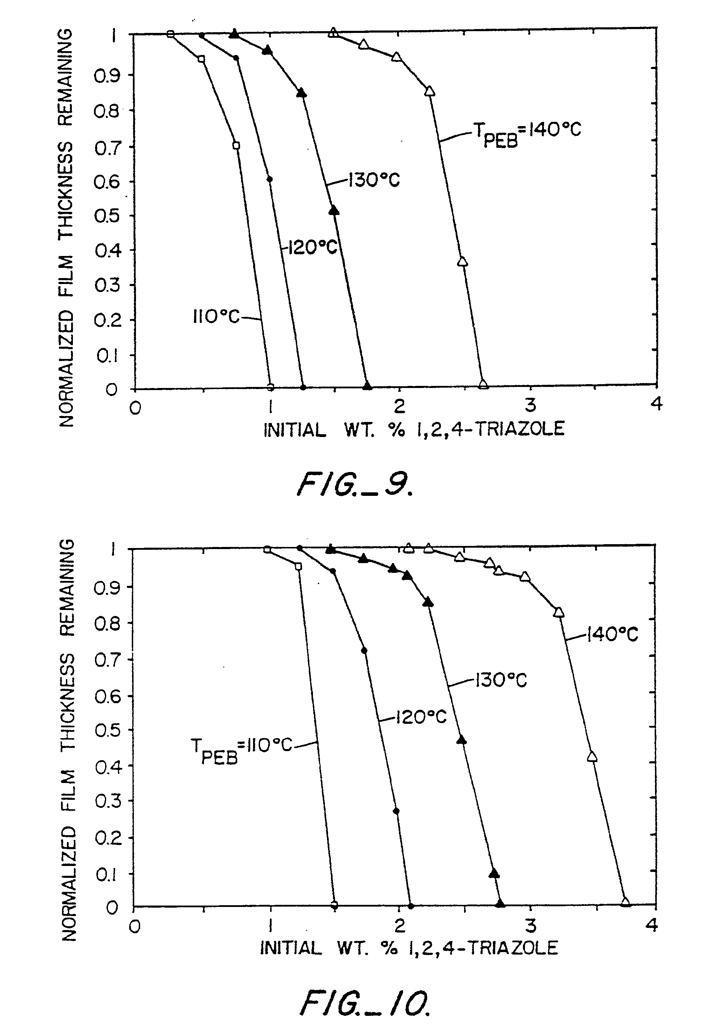

Fig. 9 is a plot of normalized film thickness remaining versus the weight percentage of 1,2,4 triazole added to SNR 248 for a fixed radiation dose of D = 1.5 J/cm². This dose is believed to be large enough to convert all of the irradiated PAG to acid. These films were not baked before exposure. Fig. 9 shows that the cross linking reaction can be inhibited completely by addition of sufficient triazole base, which may vary from 0.5-4 percent. The amount of triazole base required to inhibit the cross linking reaction will depend upon the post-exposure bake conditions, with more additive being required for higher temperature $T_{peb}$.

Fig. 10 is a plot similar to Fig. 9, but with the films receiving a pre-bake at a temperature $T_{prb}$ = 363°K for a time interval $\Delta t_{prb}$ = 60 sec. Some of the triazole base additive is lost during the pre-baking, and the initial amount of such material needed to prevent cross linking for a particular temperature $T_{peb}$ is higher in Fig. 10 than for the corresponding conditions in Fig. 9. However, sufficient triazole base is retained in the film after pre-exposure baking so that loss of additive is not a significant problem. Addition of up to 5 parts of the triazole base per hundred parts of the photoresist material SNR 248 should suffice for modest pre-exposure baking conditions.

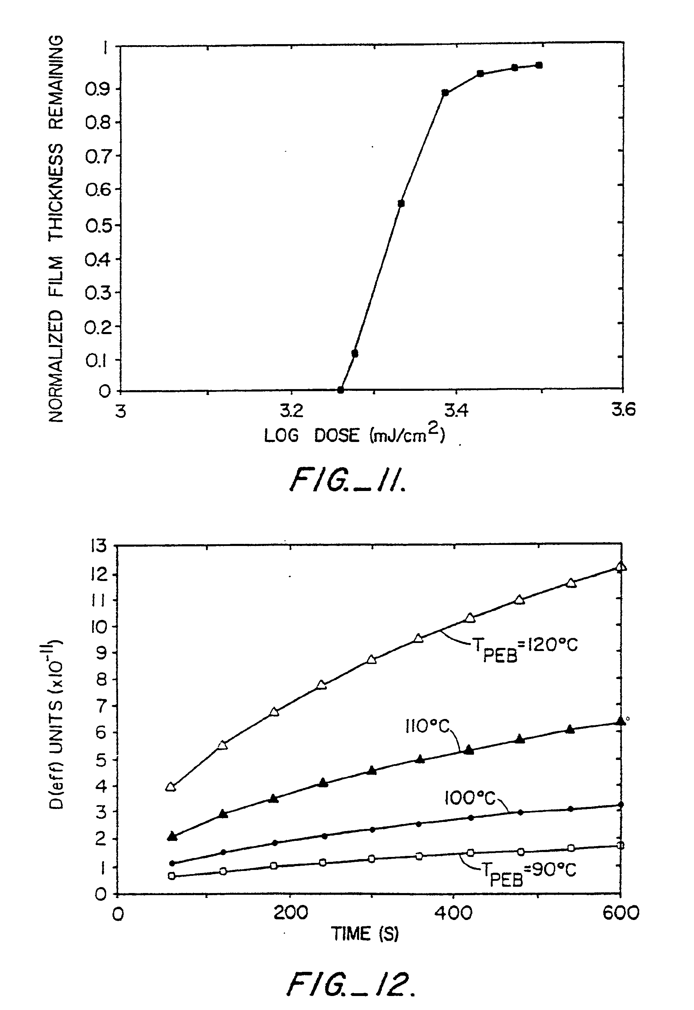

Fig. 11 shows the normalized film thickness remaining versus dose for a film of SNR 248 containing three percent by weight of the triazole base. The film was given a pre-bake at a temperature $T_{prb}$ = 363°K for a time interval $\Delta t_{prb}$ = 60 sec. Comparison of Fig. 11 with the results in Figs. 3 and 4 illustrates that the sensitivity of the PT mixture is much lower than the sensitivity of the untreated SNR 248 material. However, the contrast for such material is substantially unchanged.

Addition of a carefully chosen base to a material such as SNR 248 can controllably inhibit cross linking in the exposed regions. In order to obtain a positive image from the irradiation pattern, the base additive must be removed so that the photoresist behaves as originally intended. One method of removing the triazole base or inhibitor is to heat the film. However, heating an exposed film of SNR 248 causes cross linking of the photoresist material thus, heating must be done at modest temperatures and under carefully controlled conditions to avoid cross linking of the photoresist during removal of the triazole base.

The results shown in Fig. 11 provide at least one data point for the dose $D_{0.5}$ required to cross link the SNR 248 material with a particular set of process conditions. The effective dose $D_{eff}$ for this situation can be calculated, and equivalent sets of post-baking temperature and time values can be obtained that produce the same predicted value of $D_{eff}$. In Fig. 12, effective dose as a function of the time interval $\Delta t_{peb}$ is plotted for a sequence of values of pre-exposure bake temperature $T_{peb}$ = 363°K, 373°K, 383°K and 393°K, using a standardized incident dose of 1 J/cm². From Fig. 12, it is seen that post-baking at $T_{peb}$ = 363°K for $\Delta t_{peb}$ = 600 sec gives a similar contribution to the overall effective dose value as does post-baking at $T_{peb}$ = 373°K for a time interval A $t_{peb}$ = 75 sec. Ideally, the triazole should be removed with as low a temperature $T_{peb}$ as possible, and this is facilitated by use of longer bake times $\Delta t_{peb}$ at these lower post-bake temperatures. Use of a low temperature $T_{peb}$ also helps to preserve the photoacid generator present.

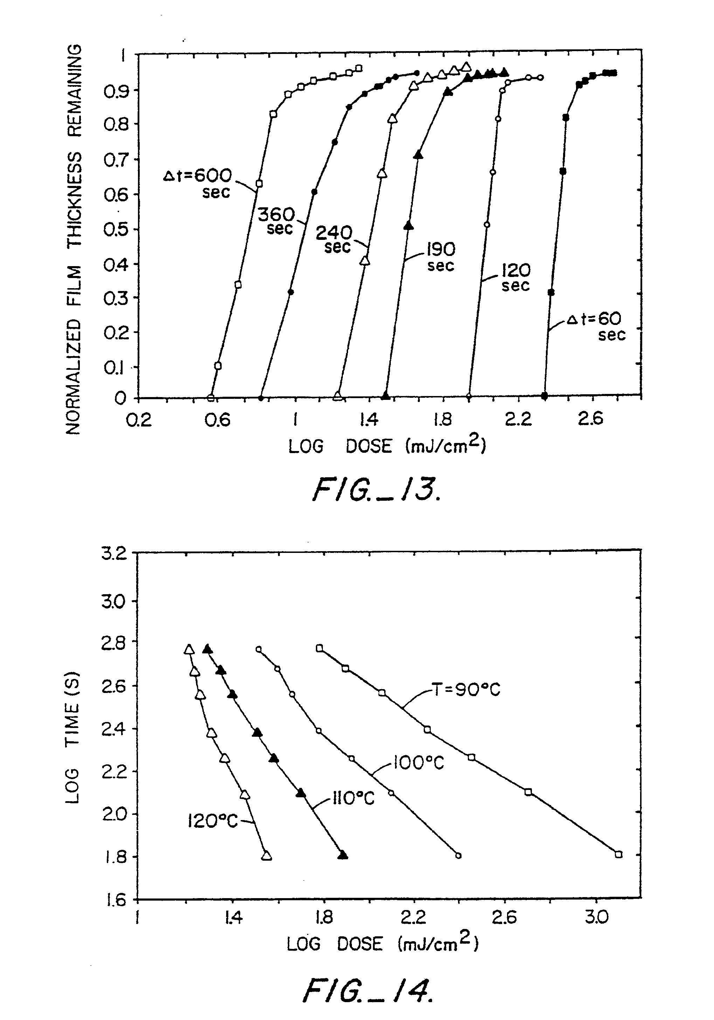

A vacuum post-bake was chosen to remove the remaining triazole base, and Fig. 13 shows the extent to which this base is removed by a vacuum bake at $T_{peb}$ = 90°K for various bake times. With a post-bake time of 600 sec, the sensitivity of the PT mixture approaches that of the untreated SNR 248 material, and the contrast of the mixture is relatively unchanged.

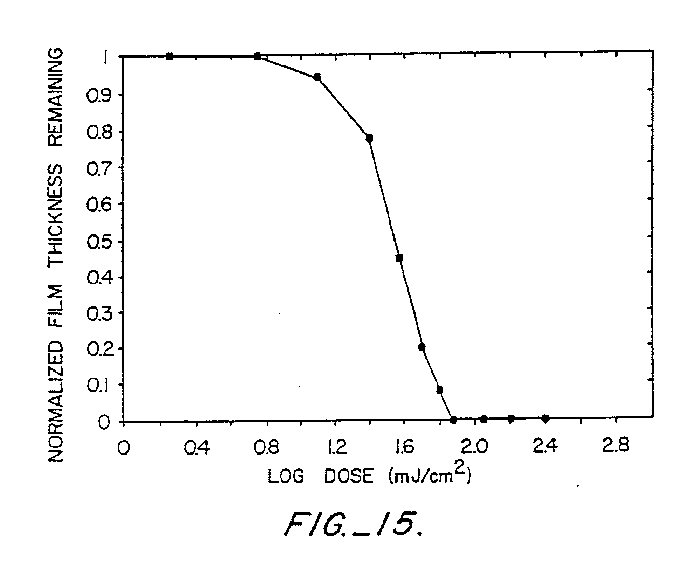

Fig. 14 is a plot of post-bake time $\Delta t_{peb}$ versus dose for a sequence of vacuum post-bake temperatures $T_{peb}$. The curves in Fig. 14 are approximately linear and appear to converge at a dose of around 15

mJ/cm$^2$, which is approximately the dose required to cross link untreated SNR 248 photoresist.

Using a selected vacuum post-bake process, one now determines the dose required to neutralize the acid in the initial exposure step. Fig. 15, which is now characteristic of a positive photoresist material illustrates normal film thickness remaining versus dose for three percent of the 1,2,4 triazole base added to SNR 248. For a pre-bake at temperature $T_{peb}$ = 363°K for a time interval $\Delta t_{peb}$ = 60 sec, no photoresist remains after an initial dose of about 100 mJ/cm$^2$, if the PT mixture is further processed with a vacuum bake and given a final blanket exposure of 250 mJ/cm$^2$. The blanket exposure dose is estimated from Fig. 14.

Example 1

A mixture of x parts of 1,2,4-triazole base (x=0.5-5) plus 100 parts of Shipley SNR 248 is prepared and is spun onto a silicon substrate so that the mixture forms a film of thickness approximately 0.85-1 μm on the substrate. The film is then baked (optional) at a temperature of $T = T_{prb}$ = 343 - 363 °K for a time interval of $\Delta t = \Delta t_{prb}$ = 45 - 75 sec at a pressure of 6 x 10$^4$ Pascals or less so that little or none of the triazole base is lost at this step. A photomask with a desired pattern is then positioned above and adjacent to the film, between the film and a light source that produces a narrow wavelength band of light centered approximately at the wavelength λ = 248 nm. This light source may be a KrF excimer laser that amplifies and emits coherent radiation at a wavelength of approximately 248.5 nm. Exposure time is such that the time-integrated dose lies in the range D = 2 - 400 mJ/cm$^2$, with a higher dose corresponding to a relatively low post-exposure baking temperature and/or baking time, and inversely. The triazole base in the exposed portion of the film is next given a post-exposure bake of a temperature of $T = T_{peb}$ = 363 - 383°K for a time interval $\Delta t = \Delta t_{peb}$ = 45 - 600 sec at an oven pressure of 6 x 10$^4$ Pascals or less. The temperature $T_{peb}$ is kept sufficiently low so that the SNR 248 material in the unexposed portion of the film is not cross linked as a result of such heating. For this purpose, the effective dose $D_{eff}$ computed by use of the Seligson et al. relation, Eq. (1), is kept much less than $D_{0.5}$ for that set of processing conditions. The film is now uniformly exposed to light of wavelength λ ≈ 248 nm so that the SNR 248 in the previously-unexposed portion of the film is now cross linked and thus rendered insoluble. The cross linking material in the previously-exposed portion of the film has been neutralized by the triazole base and has been removed in the post-exposure bake. The uniform exposure, time-integrated dose D should be high enough to cross link the remaining melamine in SNR 248. A dose of 160 mJ/cm$^2$ or more should suffice to render the previously-unexposed portion of the film completely insoluble. The film is then baked at a temperature of T = 100-140 °C to promote cross linking of the remaining melamine. Shipley MF 319 developer is next applied to the film at room temperature with agitation for a time interval $\Delta t = \Delta t_{dev}$ = 45 sec. The result of this process is a positive image of the desired pattern.

The preceding discussion has focused on the use of 1,2,4-triazole as the base for the image reversal process of this invention. Other heterocyclic compounds containing one or more N or NH groups may also be used for the base, including triazole and its other derivatives, triazine and its derivatives, pyrimidine and its derivatives, pyridazine and its derivatives, pyrolle and its derivatives, pyrollidine and its derivatives, pyrroline and its derivatives, pyrozine and its derivatives, and pyridine and its derivatives. Aliphatic bases such as trimethylamine, triethylamine and tributylamine and their derivatives may be used for the base. Other suitable choices for the base include aromatic amines such as Proton Sponge (a trademarked product of Aldrich Chemical Co.) and their derivatives, aniline and its derivatives, and ammonia vapor as used in U.S. Pat. No. 4,775,609, issued to McFarland for another image reversal process. The requirements of such a base are that: (1) the base is unaffected directly by irradiation at a relatively low wavelength $\lambda_r \leq 0.3$ nm; (2) the base readily reacts with an acid produced in adjacent photoresist molecules (produced by irradiation at the wavelength $\lambda_r$) to neutralize, partially or completely, this acid; (3) only chemically unreacted base readily evaporates when the base is subjected to post-exposure baking at a temperature of the order of T = 353-383 °K; and (4) the base is soluble in the photoresit material.

Another photoresist may be used in place of SNR 248, if the resist has relatively low absorbance (<0.4) when irradiated by light at the low wavelength $\lambda_r$ of interest and meets the following requirements: (1) the resist produces an acid in modest amounts when irradiated by light at the wavelength $\lambda_r$; (2) this acid reacts with and is neutralized by adjacent base molecules to produce a first intermediate compound; and (3) the previously unirradiated intermediate compound forms cross links when heated to temperatures of the order of T = 353-383 °K; and (4) the irradiated portion of the photoresist remains soluble in a photoresist developer after the post-irradiation baking of step 3. Another suitable photoresist is SAL 601 produced by the Shipley Company.

Claims

1. A method of processing a negative photoresist material that is normally negative to produce a positive photoresist image, the method being characterized by the steps of:

      providing a deep ultraviolet, negative type photoresist material that has the properties that (i) the photoresist produces an acid in modest amounts when irradiated by light of a wavelength $\lambda_r$, (ii) the unirradiated photoresist material forms cross links when it is heated to temperatures of at least 350°K, and (iii) a portion of the photoresist material that has been irradiated by light of wavelength approximately $\lambda_r$ with a dose of at least 20 mJ/cm$^2$ and has then been heated to a temperature of at least 350°K, is soluble in a photoresist developer, where $\lambda_r$ is a predetermined wavelength below 0.3 μm;

adding a base compound to the photoresist, in a ratio of approximately 0.5-5 parts base compound to 100 parts photoresist, to form a photoresist-base mixture, where the base compound has the properties that (i) the base is soluble in the photoresist material, (ii) the base is unaffected by irradiation by light of wavelength approximately $\lambda_r$ with a dose of no more than 1 J/cm$^2$, (iii) when the photoresist material and base compound are irradiated by light of wavelength $\lambda_r$, the acid produced by the photoresist material readily reacts with the base and is partly or completely neutralized, and (iv) any chemically unreacted base readily evaporates from the mixture of photoresist material and base, when this mixture is heated to a temperature of at least 350°K;

providing a film of the mixture of thickness in the range 0.5-2 μm;

exposing a portion of the film to deep ultraviolet light, where the exposed portion of the film is defined by a photomask positioned between the source of the ultraviolet light and the film;

allowing the photoresist component in the exposed portion of the film to form an acid, and allowing the exposed base compound to react with and neutralize the exposed photoresist component;

heating the film to a post-imaging temperature at least 70°K above room temperature, and allowing the unexposed portion of the base compound to evaporate from the film;

exposing the entire remaining film to deep ultraviolet light, and allowing the photoresist in the previously unexposed portion to form cross links;

heating the remaining film to a temperature at least 70°K above room temperature;

developing the remaining film in a photoresist developer in which the unirradiated photoresist material is soluble, to remove any remaining organic material,

whereby a positive photoresist image of the photomask pattern is formed.

2. The method of claim 1, further characterized by the step of choosing said photoresist material from the class of negative photoresist materials consisting of Shipley SNR 249 and Shipley SAL 601.

3. The method of claim 2, further characterized by the step of choosing said base compound as 1,2,4 triazole.

4. The method of claim 1, wherein said step of exposing said photomasked film to light is characterized by the steps of:
choosing said wavelength $\lambda_r$, of said ultraviolet light in the range $\lambda = 240\text{-}265$ nm; and
exposing said photomasked film to said ultraviolet light for a time interval of $\Delta t = 15\text{-}180$ sec.

5. The method of claim 1, wherein said step of heating said film to said post-imaging temperature is characterized by the step of heating said film to a post-imaging temperature in the range $T = 353\text{-}383°K$ at a pressure of no more than $p = 6 \times 10^4$ Pascals for a time interval in the range $\Delta t = 75\text{-}600$ sec.

6. The method of claim 1, wherein said step of exposing said entire film to light is characterized by the steps of:
choosing said wavelength $\lambda_r$ of said ultraviolet light in the range $\lambda = 240\text{-}265$ nm; and
exposing said entire film to said ultraviolet light for a time interval in the range of $\Delta t = 15\text{-}75$ sec.

7. The method of claim 1, further characterized by the step of heating said film to a pre-imaging temperature at least 60°K above room temperature before said photomasked film is exposed to said ultraviolet light.

8. The method of claim 7, wherein said step of heating said film to a pre-imaging temperature is further characterized by the step of heating said film to a pre-imaging temperature in the range $T = 343\text{-}413°K$ for a time interval in the range $\Delta t = 30\text{-}90$ sec at approximately atmospheric pressure.

9. The method of claim 6, further characterized by the step of limiting said exposure of said entire film to a time interval in the range of $\Delta t = 30\text{-}60$ sec.

FIG._1.

FIG._2.

FIG._3.

FIG._4.

*FIG._5.*

*FIG._6.*

FIG._7.

FIG._8.

FIG._9.

FIG._10.

FIG._11.

FIG._12.

FIG._13.

FIG._14.

FIG._15.